# EUROPEAN PATENT SPECIFICATION

(11) **EP 2 899 839 B1**
(45) Date of publication and mention of the grant of the patent: **05.07.2017**
(21) Application number: 13856887.8
(22) Date of filing: 19.11.2013
(51) Int. Cl.: H02J 7/00, H01M 10/48, H02J 7/02, G01R 31/36

(54) **BATTERY MANAGEMENT DEVICE, CONTROL METHOD AND PROGRAM THEREFOR, AND BATTERY MONITORING SYSTEM PROVIDED WITH SAME**
BATTERIEVERWALTUNGSVORRICHTUNG, STEUERUNGSVERFAHREN UND -PROGRAMM DAFÜR SOWIE BATTERIEÜBERWACHUNGSSYSTEM DAMIT
DISPOSITIF DE GESTION DE BATTERIE, SA MÉTHODE ET SON PROGRAMME DE COMMANDE, ET SYSTÈME DE SURVEILLANCE DE BATTERIE DOTÉ DE CEUX-CI

(30) Priority: 20.11.2012 JP 2012254478
(43) Date of publication of application: 29.07.2015
(73) Proprietor: Mitsubishi Heavy Industries, Ltd., Tokyo 108-8215 (JP)
(72) Inventor: MATSUMURA, Hitoshi, Tokyo 108-8215 (JP); TAKEYAMA, Akira, Tokyo 108-8215 (JP)
(74) Representative: Hoffmann Eitle
(86) International application number: PCT/JP2013/081106
(87) International publication number: WO 2014/080881

(56) References cited:
- JP-A- 2002 110 259
- JP-A- 2009 089 486
- JP-A- 2010 141 971
- US-A1- 2011 080 138
- US-A1- 2011 175 574
- US-A1- 2011 273 023
- US-A1- 2012 268 069

## Description

### Technical Field

The present invention relates to a battery management device, a control method and program therefor, and a battery monitoring system including the same.

### Background Art

For example, in a battery pack configured to include a plurality of secondary batteries, such as lithium batteries, the state information of each battery (for example, temperature of the battery surface) is monitored by a monitoring device called a cell monitor unit (CMU) that monitors each battery pack. Each of a plurality of CMUs transmits the acquired battery state information to a battery management system (BMU) that manages the operation of the CMU and the state of each battery. In this case, the BMU numbers each CMU according to an identification signal, and performs an operation for association between the given identification number and the battery state information from each CMU. In addition, the BMU checks whether or not each CMU is operating properly based on the battery information and the identification number, thereby determining the occurrence of failure in each CMU. As a numbering method using the identification signal, a configuration is disclosed in which CMUs are connected in series (daisy-chained) and numbering is performed according to the identification signal in a sequence in which the respective CMUs have been activated (for example, refer to PTL 1 below).

### Citation List

### Patent Literature

[PTL 1] Japanese Unexamined Patent Application Publication No. 2010-141971

### Summary of Invention

### Technical Problem

In the method disclosed in PTL 1 described above, if work for replacing the CMU is performed after the identification number is given to each CMU, the number given to the CMU and the arrangement position of the CMU can no longer be associated with each other. However, even if the given number and the arrangement position are different, the battery system operates normally. However, when a failure or the like occurs and the CMU is replaced or removed, if the given number and the arrangement position are different, the arrangement position of the CMU that has failed cannot be correctly checked. For this reason, a problem has occurred in that the corresponding CMU cannot be selected accurately.

It is an object of the present invention to provide a battery management device that can quickly and accurately check the arrangement position of a monitoring device that monitors battery packs when an abnormality occurs in the monitoring device, a control method and program therefor, and a battery monitoring system including the same.

### Solution to Problem

A first aspect of the present invention is a battery management device that acquires, from each of a plurality of monitoring devices that monitor a plurality of battery packs each including one or more secondary battery cells, battery state information of the corresponding battery pack. The battery management device includes: comparison means for comparing a sequence number when each of the monitoring devices is activated with an identification number, which is assigned to each of the monitoring devices and is acquired from the monitoring device, when the monitoring device is activated in a predetermined sequence; and change means for changing the identification number to the same number as the sequence number and outputting the new identification number after the change to the monitoring device when the sequence number is different from the identification number.

In addition, the predetermined sequence to activate the monitoring device is, for example, a connection sequence from the upstream side connected to the battery management device, a magnitude sequence of the voltage of the corresponding battery pack, and a magnitude sequence of the radio field intensity when the monitoring device is connected to the battery management device by wireless communication.

According to the first aspect of the present invention, the identification number assigned to the monitoring device is made to match the same number as the sequence number when the monitoring device has been activated. Therefore, if the arrangement position can be estimated from the sequence number when the monitoring device has been activated, when failure or the like occurs in the monitoring device, the arrangement position of the monitoring device that has failed can be quickly and accurately checked based on the identification number (identification information).

The battery management device described above may be configured to include storage means for storing the identification number and specific information to identify the monitoring device so as to match each other.

Through this configuration, specific information for identifying the monitoring device is managed. Therefore, replacement of monitoring devices, introduction of a new monitoring device, or the like can be reliably detected.

Preferably, when the sequence number and the identification number match each other, the change means outputs a monitoring device activation command to the monitoring device, for which the sequence number and the identification number have been compared with each other, without changing the identification number of the monitoring device, so that the monitoring device on a downstream side that is opposite to the battery management device when the battery management device side is assumed to be an upstream side is activated.

Through this configuration, when the identification number is not changed, it is possible to quickly proceed to the comparison processing of the next monitoring device.

Preferably, the monitoring device outputs contact information indicating normal when connection switching means is in a connection state and outputs contact information indicating a failure when the connection switching means is in a non-connection state, the connection switching means performing switching between connection and non-connection with respect to a downstream side on an opposite side to the battery management device when the battery management device side is assumed to be an upstream side. The battery management device preferably includes determination means for determining the monitoring device that outputs the contact information indicating normal to be the monitoring device at an end when the contact information indicating normal is detected in an initial state.

Through this configuration, based on the contact information, it can be easily determined whether or not the monitoring device of interest is a monitoring device for which a terminating resistor is provided on the downstream side.

A second aspect of the present invention is a control method of a battery management device that acquires, from each of a plurality of monitoring devices that monitor a plurality of battery packs each including one or more secondary battery cells, battery state information of the corresponding battery pack. The control method of a battery management device includes: a first step of comparing a sequence number when each of the monitoring devices is activated with the identification number, which is assigned to each of the monitoring devices and is acquired from the monitoring device, when the monitoring device is activated in a predetermined sequence; and a second step of changing the identification number to the same number as the sequence number and outputting the new identification number after the change to the monitoring device when the sequence number is different from the identification number.

A third aspect of the present invention is a control program of a battery management device that acquires, from each of a plurality of monitoring devices that monitor a plurality of battery packs each including one or more secondary battery cells, battery state information of the corresponding battery pack. The control program of a battery management device causes a computer to execute: a first process of comparing a sequence number when each of the monitoring devices is activated with the identification number, which is assigned to each of the monitoring devices and is acquired from the monitoring device, when the monitoring device is activated in a predetermined sequence; and a second process of changing the identification number to the same number as the sequence number and outputting the new identification number after the change to the monitoring device when the sequence number is different from the identification number.

### Advantageous Effects of Invention

According to the present invention, it is possible to quickly and accurately check the arrangement position of a monitoring device that monitors battery packs when an abnormality occurs in the monitoring device.

### Brief Description of Drawings

Fig. 1 is a diagram showing the schematic configuration of a battery monitoring system according to the present invention.
Fig. 2 shows an example of a log obtained by matching an identification number and specific information with each other.
Fig. 3 shows an operation flow of the battery monitoring system according to the present invention.
Fig. 4 shows an operation flow of the end determination of the battery monitoring system according to the present invention.

### Description of Embodiments

Hereinafter, an embodiment of a battery management device according to the present invention, a control method and program therefor, and a battery monitoring system including the same will be described with reference to the diagrams.

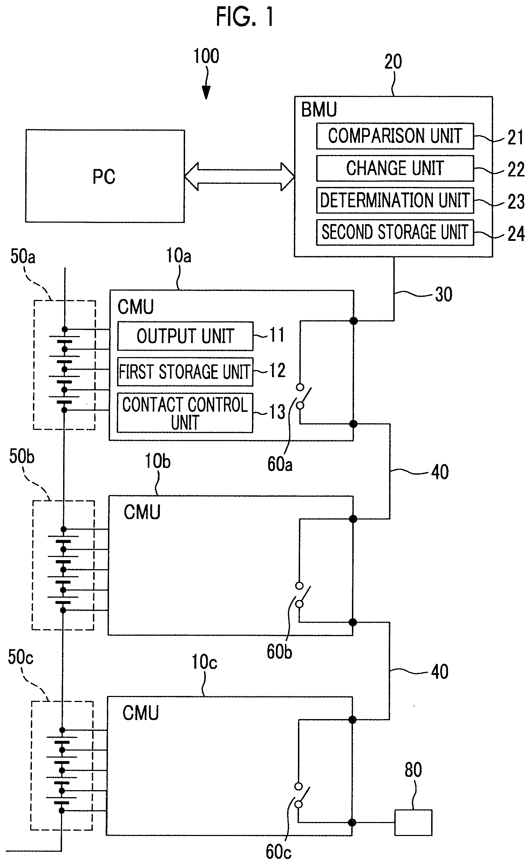

Fig. 1 is a diagram showing the schematic configuration of a battery monitoring system according to an embodiment of the present invention. As shown in Fig. 1, a battery monitoring system 100 according to the present embodiment is configured to include a plurality of monitoring devices (hereinafter, referred to as "CMUs") 10a, 10b, and 10c, a battery management device (hereinafter, referred to as a "BMU") 20, a first communication line 30, a second communication line 40, a plurality of battery packs 50a, 50b, and 50c, and connection switching units 60a, 60b, and 60c as main components. Hereinafter, unless otherwise stated, the CMU, the battery pack, and the connection switching unit are described as a CMU 10, a battery pack 50, and a connection switching unit 60, respectively.

The battery pack 50 has a configuration in which one battery cell or a plurality of battery cells are connected in series, so that electric power can be supplied to a load (not shown). A voltage sensor (not shown) for detecting the voltage of the battery cell and a temperature sensor (not shown) for detecting the temperature are provided in each battery cell. The detection results of the voltage sensor and the temperature sensor are output to the CMU 10 provided corresponding to each battery pack 50. As shown in Fig. 1, in the present embodiment, in the battery pack 50, four battery cells form one battery pack. However, the number of cells is not limited thereto. In addition, the secondary battery is a lithium ion battery or a lead acid battery, for example.

The CMU 10 is configured to include a central processing unit (CPU), a random access memory (RAM), a computer-readable recording medium, and the like that are not shown, for example. A series of processes for realizing various functions to be described later are recorded in a recording medium or the like in the form of a program. When the CPU reads the program with the RAM or the like and executes information processing and arithmetic processing of information, the various functions to be described later are realized.

The CMUs 10 are daisy-chained by the second communication line 40. Among the plurality of CMUs 10a, 10b, and 10c, a CMU (for example, the CMU 10a) located at one end is connected to the BMU 20 through the first communication line 30. In addition, among the plurality of CMUs 10a, 10b, and 10c, a CMU (for example, the CMU 10c) located at the other end, which is not the one end, is connected to a terminating portion 80 that is a terminating resistor. In the battery monitoring system 100 according to the present embodiment, the BMU 20 side is defined as an upstream side, and the opposite side to the BMU 20 side is defined as a downstream side. The connection switching units 60a, 60b, and 60c for switching the connection and non-connection between the CMUs 10 are provided in the second communication line 40 for connecting the CMUs 10 to each other, and all of the connection switching units 60a, 60b, and 60c are in a non-connection state in the initial state.

Here, an example of how to activate the CMUs 10a, 10b, and 10c will be described. First, the CMU 10a on the upstream side that is connected to the BMU 20 through the first communication line 30 is activated when a monitoring device activation command is acquired from the BMU 20, and the connection switching unit 60a for connection with the CMU 10b located on the downstream side next to the CMU 10a is switched to the connection state to make the CMU 10b and the BMU 20 communicable with each other and a response signal is transmitted to the BMU 20. Then, when the response signal is received from the CMU 10a, the BMU 20 transmits a monitoring device activation command to the CMU 10b. Then, the CMU 10b is activated when the monitoring device activation command is acquired from the BMU 20, and the connection switching unit 60c for connection with the CMU 10c located on the downstream side next to the CMU 10b is switched to the connection state to make the CMU 10c and the BMU 20 communicable with each other and a response signal is transmitted to the BMU 20. Thus, the CMUs 10a, 10b, and 10c are activated in a sequence in which the CMUs 10a, 10b, and 10c are daisy-chained.

Each of the CMUs 10a, 10b, and 10c includes an output unit (output means) 11, a first storage unit 12, a contact control unit 13, and the connection switching unit 60. Unless otherwise described, each unit provided in the CMUs 10a, 10b, and 10c functions similarly.

The first storage unit 12 stores an identification number (given number) given in advance by predetermined means and specific information (for example, a serial number, specific manufacturing date, and the like) for identifying the CMU 10, which is assigned to each CMU 10, so as to match each other. The identification number can be rewritten.

The output unit 11 reads an identification number and specific information assigned to each CMU 10 from the first storage unit 12 based on the reading command of the identification number and specific information, and outputs the identification number and the specific information to the BMU 20. In addition, the output unit 11 outputs the battery state information of the battery pack 50 to be monitored, which corresponds to the CMU 10, to the BMU 20 based on the reading command of the battery state information of the battery pack 50.

The contact control unit 13 outputs information indicating whether the contact destination for connection to the terminating portion 80 or the second communication line 40, which enables communication with the CMU 10 on the downstream side, is an open circuit or a closed circuit (hereinafter, referred to as "contact information") to the BMU 20. That is, assuming that the CMU 10a is a reference, when the CMU 10a is connected to the CMU 10b through the second communication line 40 and the connection switching unit 60b of the CMU 10b is open, contact information indicating "failure" as an open circuit is output to the BMU 20. On the other hand, assuming that the CMU 10c is a reference, when the CMU 10c is connected to the terminating portion (ground) 80 through the second communication line 40 and the BMU 20 is grounded, the BMU 20, the CMUs 10a, 10b, and 10c, and the terminating resistor are in a state of being a substantially closed circuit. Accordingly, contact information indicating "normal" is output to the BMU 20.

In the battery monitoring system 100 of the present embodiment, the contact information of "failure" is used as information indicating that the BMU 20, the first communication line 30, the CMU 10, and the second communication line 40 are in a state of being an open circuit.

As described above, based on the monitoring device activation command acquired from the BMU 20, the contact control unit 13 switches the connection switching unit 60 between the corresponding CMU 10 and another CMU 10, which is located on the downstream side next to the corresponding CMU 10, to the connection state so that another CMU 10 on the downstream side and the BMU 20 can communicate with each other.

The BMU 20 is configured to include a central processing unit (CPU), a random access memory (RAM), a computer-readable recording medium, and the like that are not shown, for example. A series of processes for realizing various functions to be described later are recorded in a recording medium or the like in the form of a program. When the CPU reads the program with the RAM or the like and executes information processing and arithmetic processing of information, the various functions to be described later are realized.

The BMU 20 activates each CMU 10, and acquires the battery state information of the battery pack 50 corresponding to the CMU 10 from each CMU 10. Specifically, the BMU 20 includes a comparison unit (comparison means) 21, a change unit (change means) 22, a determination unit (determination means) 23, and a second storage unit (storage means) 24.

When the CMU 10 is activated in a predetermined sequence, the comparison unit 21 compares a sequence number, which is the sequence of activation of the CMU 10 counted by the BMU 20, with the identification number acquired from the CMU 10.

When the sequence number is different from the identification number, the change unit 22 changes the identification number into the same number as the sequence number, and outputs a new identification number after the change to the CMU 10. After outputting the new identification number after the change to the CMU 10, the change unit 22 outputs a monitoring device activation command to the CMU 10, thereby activating the CMU 10 on the downstream side that is opposite to the BMU 20 when the BMU 20 side is assumed to be the upstream side with respect to the CMU 10 for which the sequence number and the identification number have been compared with each other.

When the sequence number and the identification number match each other, the change unit 22 outputs a monitoring device activation command without changing the identification number of the CMU 10, thereby activating the CMU 10 on the downstream side that is opposite to the BMU 20 when the BMU 20 side is assumed to be the upstream side with respect to the CMU 10 for which the sequence number and the identification number have been compared with each other. Thus, when the identification number is not changed, it is possible to quickly proceed to the comparison processing of the next CMU 10. Even when the sequence number and the identification number match each other, the identification number may be output to the CMU 10 in the same manner as when the sequence number is different from the identification number.

Thus, the change unit 22 assigns an identification number so that the sequence number and the identification information when activating each CMU 10 in a predetermined sequence match each other.

In addition, since the BMU 20 activates the CMU 10 in a predetermined sequence, the number of the sequence number (that is, identification number) of the last CMU 10 can be recognized as the number of connected CMUs 10 that are connected to the BMU 20. Therefore, the appropriate number of cells for the BMU 20 or the number of connected CMUs 10 does not need to be input or stored in advance in the BMU 20 for each configuration of the system. In this case, the time required for the system configuration is saved, or the time and effort required to change the BMU 20 when the configuration of the system has been changed are saved.

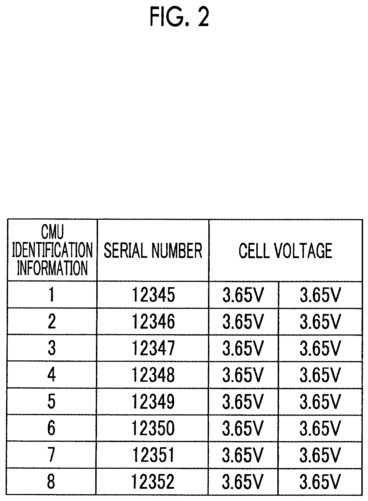

The second storage unit 24 stores an identification number and specific information (for example, a serial number) for identifying each CMU 10 so as to match each other. Fig. 2 shows an example of a log obtained by matching the identification number and specific information of the CMU 10 stored in the second storage unit 24.

The determination unit 23 determines that the CMU 10 that has output the contact information indicating "normal" is the CMU 10 at the end, in other words, determines that the terminating portion 80 is provided on the downstream side of the CMU 10 when the contact information indicating "normal" is detected. Thus, the determination unit 23 performs end determination easily through end determination based on the connection and non-connection information included in the contact information.

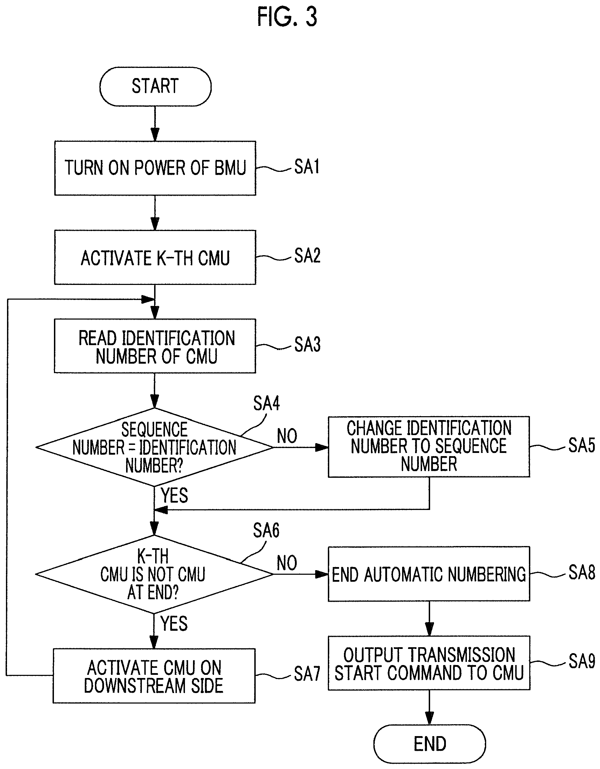

Next, the operation of the battery monitoring system 100 according to the present embodiment will be described with reference to Figs. 1 and 3. Here, a case where the BMU 20 and the CMU 10 are daisy-chained will be described as an example.

When the BMU 20 is turned on (step SA1 in Fig. 3), a command to activate the first CMU 10a is output from the BMU 20. The first CMU 10a is the CMU 10 on the most upstream side that is daisy-chained to the BMU 20 through the first communication line 30. When a monitoring device activation command to activate the first CMU 10a is acquired, the connection switching unit 60a is switched to the connection state so as to activate the first CMU 10a (step SA2 in Fig. 3). The CMU 10a reads an identification number and specific information assigned to the CMU 10a from the first storage unit 12 based on the reading command of the identification number and specific information, and outputs the identification number and the specific information to the BMU 20.

The BMU 20 reads the identification number from the CMU 10 (step SA3 in Fig. 3), and compares the identification number with the sequence number when the CMU 10 has been activated and determines whether or not the identification number and the sequence number match each other (step SA4 in Fig. 3). When the identification number does not match the sequence number, the identification number is changed (rewritten) to the sequence number (step SA5 in Fig. 3), and the process proceeds to the next step SA6. When the identification number matches the sequence number, it is determined whether or not the first CMU 10a is the CMU 10 at the end (step SA6 in Fig. 3).

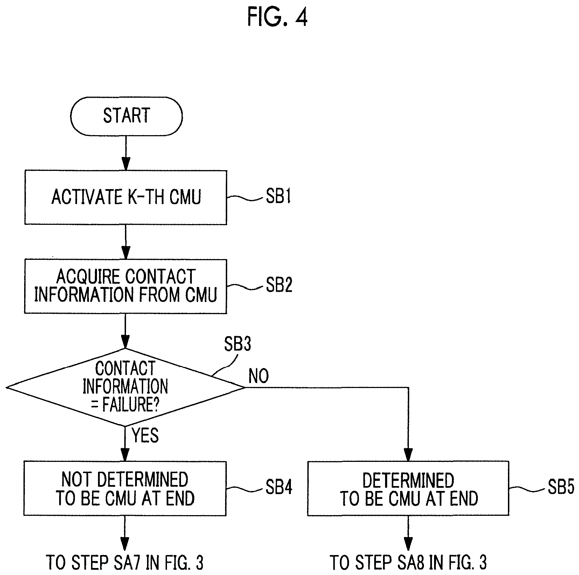

Here, determination regarding the CMU 10 at the end will be specifically described with reference to the operation flow in Fig. 4.

When the CMU 10 is activated (step SB1 in Fig. 4), contact information depending on whether another CMU 10 or the terminating portion 80 is located on the downstream side next to the CMU 10 is output from the CMU 10, and is input to the BMU 20 (step SB2 in Fig. 4). It is determined whether or not the contact information is "failure" (step SB3 in Fig. 4). When the contact information is "failure", it is determined that the CMU 10 is not the CMU 10 at the end (step SB4 in Fig. 4), and the process proceeds to step SA7 in Fig. 3.

When it is determined that the first CMU 10a is not located at the end, a monitoring device activation command is output to the second CMU 10b from the BMU 20. When the monitoring device activation command is acquired, the second CMU 10b is activated by switching the connection switching unit 60b to the connection state (step SA7 in Fig. 3), and the process returns to step SA3 in Fig. 3 in which the process described above is executed for the second CMU 10b and is repeated until the K-th CMU 10.

When the contact information is not "failure" (that is, when the contact information is "normal"), it is determined that the CMU 10 is the CMU 10 at the end (step SB5 in Fig. 4), and the automatic numbering process for giving an identification number to the CMU 10 is ended (step SA8 in Fig. 3). A transmission start command to start the control of the normal battery system is output from the BMU 20 to each CMU 10 (step SA9 in Fig. 3), and this process is ended.

The BMU 20 starts normal communication with each CMU 10 when the allocation of identification information up to the CMU 10 at the end is completed. Specifically, after the identification information is given, the BMU 20 acquires the battery state information of the battery packs 50a, 50b, and 50c connected to the CMUs 10a, 10b, and 10c from the CMUs 10a, 10b, and 10c, and manages the battery state information. The battery state information is, for example, a voltage value received from a voltage sensor provided in each battery pack and a temperature value received from a temperature sensor. For example, when an abnormality occurs in a certain battery pack 50 (when an abnormality of a voltage between terminals, overcurrent, or the like occurs), error information is output to a PC or the like connected to the BMU 20.

As described above, in the battery management device 20, the control method and program therefor, and the battery monitoring system 100 including the same according to the present embodiment, when the CMU 10 is activated in a predetermined sequence, the BMU 20 compares the identification number output from each CMU 10 with the sequence number when the CMU 10 has been activated, and outputs to the CMU 10 a new identification number after changing the identification number to the same number as the sequence number when the identification number is different from the sequence number. In addition, the predetermined sequence to activate the CMU 10 is, for example, a connection sequence from the upstream side connected to the BMU 20, a magnitude sequence of the voltage of the corresponding battery pack, or a magnitude sequence of the radio field intensity when the CMU 10 is connected to the BMU 20 by wireless communication.

Thus, the identification number assigned to the CMU 10 is made to match the same number as the sequence number when the CMU 10 has been activated. Accordingly, if the arrangement position can be estimated from the sequence number when the CMU 10 has been activated, when a failure or the like occurs in the CMU 10, the arrangement position of the CMU 10 that has failed can be quickly and accurately checked based on the identification information. As a result, it is possible to accurately select the CMU 10 corresponding to the failure or the like.

In the related art, it is checked whether or not the identification number is correctly given by comparing the identification number (numbering) with the number of cells input to the battery management device (BMU) in advance. Therefore, for example, when a cell or a monitoring device (CMU) is added during the operation and the duplication of an identification number occurs, it has not been possible to detect the duplication of the identification number. In the present embodiment, since the monitoring device (CMU) is activated in a predetermined sequence and the identification number is appropriately rewritten to the sequence number for activation, the number of cells can be correctly checked even if a cell or the CMU 10 is added after the introduction.

In addition, in the present embodiment, detailed information (for example, specific date of manufacture, a serial number, and the like) as a part of the CMU 10 is stored on the BMU 20 side. Accordingly, it is possible to check the details of the CMU 10 on the BMU 20 side. That is, not only the identification number but also detailed information, such as the serial number of the CMU 10, is managed. Accordingly, even if not only the missing or duplication of the CMU 10 but also the replacement of the CMU 10 is performed, it is possible to detect it correctly.

In the present embodiment, explanation has been given on the assumption that a plurality of CMUs 10 are connected in series (daisy-chained), but, the present invention is not limited thereto. As long as the CMU 10 can be activated in a predetermined sequence, a plurality of CMUs 10 may be connected in parallel, and the connection form is not particularly limited.

In addition, although the CMU 10 is provided for each battery pack in the battery device according to the present embodiment, the present invention is not limited thereto. For example, a battery management unit may be provided for each battery cell, or it is possible to set a plurality of battery cells as one group and provide the CMU 10 for each group.

In addition, in the battery device according to the present embodiment, the example has been mentioned in which three battery packs are connected in series. However, the present invention is not limited thereto, and there is no particular upper limit.

### Reference Signs List

- 10a, 10b, the 10c:: CMU (monitoring device)
- 20:: BMU (battery management device)
- 30:: first communication line
- 40:: second communication line
- 50a, 50b, 50c:: battery pack
- 60a, 60b, 60c:: connection switching unit

## Claims

1. A battery management device that acquires, from each of a plurality of monitoring devices that monitor a plurality of battery packs each including one or more secondary battery cells, battery state information of the corresponding battery pack, **characterized by** comprising:
comparison means for comparing a sequence number when each of the monitoring devices is activated with an identification number, which is assigned to each of the monitoring devices and is acquired from the monitoring device, when the monitoring device is activated in a predetermined sequence; and
change means for changing the identification number to the same number as the sequence number and outputting the new identification number after the change to the monitoring device when the sequence number is different from the identification number.

2. The battery management device according to claim 1, further comprising:
storage means for storing the identification number and specific information to identify the monitoring device so as to match each other.

3. The battery management device according to claim 1 or 2,
wherein, when the sequence number and the identification number match each other, the change means outputs a monitoring device activation command to the monitoring device, for which the sequence number and the identification number have been compared with each other, without changing the identification number of the monitoring device, so that the monitoring device on a downstream side that is opposite to the battery management device when the battery management device side is assumed to be an upstream side is activated.

4. The battery management device according to any one of claims 1 to 3,
wherein the monitoring device outputs contact information indicating normal when connection switching means is in a connection state and outputs contact information indicating a failure when the connection switching means is in a non-connection state, the connection switching means performing switching between connection and non-connection with respect to a downstream side on an opposite side to the battery management device when the battery management device side is assumed to be an upstream side, and
the battery management device includes determination means for determining the monitoring device that outputs the contact information indicating normal to be the monitoring device at an end when the contact information indicating normal is detected in an initial state.

5. A control method of a battery management device that acquires, from each of a plurality of monitoring devices that monitor a plurality of battery packs each including one or more secondary battery cells, battery state information of the corresponding battery pack, the method **characterized by** comprising:
a first step of comparing a sequence number when each of the monitoring devices is activated with the identification number, which is assigned to each of the monitoring devices and is acquired from the monitoring device, when the monitoring device is activated in a predetermined sequence; and
a second step of changing the identification number to the same number as the sequence number and outputting the new identification number after the change to the monitoring device when the sequence number is different from the identification number.

6. A control program of a battery management device that acquires, from each of a plurality of monitoring devices that monitor a plurality of battery packs each including one or more secondary battery cells, battery state information of the corresponding battery pack, **characterized in that** the program causing a computer to execute:
a first process of comparing a sequence number when each of the monitoring devices is activated with the identification number, which is assigned to each of the monitoring devices and is acquired from the monitoring device, when the monitoring device is activated in a predetermined sequence; and
a second process of changing the identification number to the same number as the sequence number and outputting the new identification number after the change to the monitoring device when the sequence number is different from the identification number.

7. A battery monitoring system, comprising:
a plurality of monitoring devices that monitor a plurality of battery packs each including one or more secondary battery cells; and
a battery management device that acquires battery state information of the corresponding battery pack from each of the monitoring devices,
wherein each of the monitoring devices includes output means for outputting an assigned identification number, and **characterized in that** the battery management device includes:
comparison means for comparing a sequence number when the monitoring device is activated with the identification number acquired from the monitoring device when the monitoring device is activated in a predetermined sequence; and
change means for changing the identification number to the same number as the sequence number and outputting the new identification number after the change to the monitoring device when the sequence number is different from the identification number.

## Patentansprüche

1. Batterieverwaltungseinrichtung, die von jeder von einer Mehrzahl von Überwachungseinrichtungen, die eine Mehrzahl von Batteriepacks überwachen, die jeweils eine oder mehrere Sekundärbatteriezellen enthalten, eine Batteriezustandsinformation des zugehörigen Batteriepacks bezieht, **dadurch gekennzeichnet, dass** sie umfasst:
eine Vergleichseinrichtung zum Vergleichen einer Sequenzzahl, wenn jede der Überwachungseinrichtungen mit einer Identifikationszahl aktiviert wird, welche jeder der Überwachungseinrichtungen zugeordnet ist und von der Überwachungseinrichtung bezogen wird, wenn die Überwachungseinrichtung in einer vorbestimmten Sequenz aktiviert wird; und
eine Veränderungseinrichtung zum Verändern der Identifikationszahl auf die gleiche Zahl wie die Sequenzzahl und Ausgeben der neuen Identifikationszahl nach der Veränderung an die Überwachungseinrichtung, wenn die Sequenzzahl verschieden von der Identifikationszahl ist.

2. Batterieverwaltungseinrichtung nach Anspruch 1, ferner umfassend:
eine Speichereinrichtung zum Speichern der Identifikationszahl und spezifischer Information zum Identifizieren der Überwachungseinrichtung, so dass sie zueinander passen.

3. Batterieverwaltungseinrichtung nach Anspruch 1 oder 2,
wobei, wenn die Sequenzzahl und die Identifikationszahl zueinander passen, die Veränderungseinrichtung einen Überwachungseinrichtung-Aktivierungsbefehl an die Überwachungseinrichtung ausgibt, für welche die Sequenzzahl und die Identifikationszahl miteinander verglichen wurden, ohne die Identifikationszahl der Überwachungseinrichtung zu verändern, so dass die Überwachungseinrichtung auf einer stromabwärtigen Seite, die der Batterieverwaltungseinrichtung entgegengesetzt ist, wenn angenommen wird, dass die Seite der Batterieverwaltungseinrichtung eine stromaufwärtige Seite ist, aktiviert wird.

4. Batterieverwaltungseinrichtung nach einem der Ansprüche 1 bis 3,
wobei die Überwachungseinrichtung eine Kontaktinformation ausgibt, die normal anzeigt, wenn eine Verbindungs-Schalteinrichtung in einem Verbindungszustand ist, und eine Kontaktinformation ausgibt, die ein Fehlverhalten anzeigt, wenn die Verbindungs-Schalteinrichtung in einem Nichtverbindungszustand ist, wobei die Verbindungs-Schalteinrichtung ein Schalten zwischen einer Verbindung und einer Nichtverbindung in Bezug auf eine stromabwärtigen Seite auf einer entgegengesetzten Seite zu der Batterieverwaltungseinrichtung, wenn angenommen wird, dass die Batterieverwaltungseinrichtung eine stromaufwärtigen Seite ist, durchführt, und
wobei die Batterieverwaltungseinrichtung eine Bestimmungseinrichtung zum Bestimmen, dass die Überwachungseinrichtung umfasst, die die Kontaktinformation ausgibt, die normal anzeigt, die Überwachungseinrichtung an einem Ende sein soll, wenn die Kontaktinformation, die normal anzeigt, in einem Anfangszustand detektiert wird.

5. Steuerungsverfahren einer Batterieverwaltungseinrichtung, die von jeder von einer Mehrzahl von Überwachungseinrichtungen, die eine Mehrzahl von Batteriepacks überwachen, die jeweils eine oder mehrere Sekundärbatteriezellen enthalten, eine Batteriezustandsinformation des zugehörigen Batteriepacks bezieht, wobei das Verfahren **dadurch gekennzeichnet ist, dass** es umfasst:
einen ersten Schritt, in welchem eine Sequenzzahl, wenn jede der Überwachungseinrichtungen aktiviert wird, mit der Identifikationszahl verglichen wird, die jeder der Überwachungseinrichtungen zugeordnet ist und von der Überwachungseinrichtung bezogen wird, wenn die Überwachungseinrichtung in einer vorbestimmten Sequenz aktiviert wird; und
einen zweiten Schritt, in welchem die Identifikationszahl auf die gleiche Zahl wie die Sequenzzahl geändert wird und die neue Identifikationszahl nach der Veränderung an die Überwachungseinrichtung ausgegeben wird, wenn die Sequenzzahl verschieden von der Identifikationszahl ist.

6. Steuerungsprogramm einer Batterieverwaltungseinrichtung, die von jeder von einer Mehrzahl von Überwachungseinrichtungen, die eine Mehrzahl von Batteriepacks überwachen, die jeweils eine oder mehrere Sekundärbatteriezellen enthalten, eine Batteriezustandsinformation des zugehörigen Batteriepacks bezieht, **dadurch gekennzeichnet, dass** das Programm einen Computer zum Ausführen des folgenden veranlasst:
einen ersten Prozess, in welchem eine Sequenzzahl, wenn jede der Überwachungseinrichtungen aktiviert wird, mit der Identifikationszahl verglichen wird, die jeder der Überwachungseinrichtungen zugeordnet ist und von der Überwachungseinrichtung bezogen wird, wenn die Überwachungseinrichtung in einer vorbestimmten Sequenz aktiviert wird; und
einen zweiten Prozess, in welchem die Identifikationszahl auf die gleiche Zahl wie die Sequenzzahl geändert wird und die neue Identifikationszahl nach der Veränderung an die Überwachungseinrichtung ausgegeben wird, wenn die Sequenzzahl verschieden von der Identifikationszahl ist.

7. Batterieüberwachungssystem, umfassend: eine Mehrzahl von Überwachungseinrichtungen, die eine Mehrzahl von Batteriepacks überwachen, die jeweils eine oder mehrere Sekundärbatteriezellen enthalten; und
eine Batterieverwaltungseinrichtung, die Batteriezustandsinformationen des zugehörigen Batteriepacks von jeder der Überwachungseinrichtungen bezieht,
wobei jede der Überwachungseinrichtungen eine Ausgabeeinrichtung zum Ausgeben einer zugeordneten Identifikationszahl aufweist, und **dadurch gekennzeichnet, dass** die Batterieverwaltungseinrichtung umfasst:
eine Vergleichseinrichtung zum Vergleichen einer Sequenzzahl, wenn die Überwachungseinrichtung aktiviert wird, mit der Identifikationszahl, die von der Überwachungseinrichtung bezogen wurde, wenn die Überwachungseinrichtung in einer vorbestimmten Sequenz aktiviert wird; und
eine Veränderungseinrichtung zum Verändern der Identifikationszahl auf die gleiche Zahl wie die Sequenzzahl und Ausgeben der neuen Identifikationszahl nach der Veränderung an die Überwachungseinrichtung, wenn die Sequenzzahl verschieden von der Identifikationszahl ist.

## Revendications

1. Dispositif de gestion de batterie qui acquiert, à partir de chacun d'une pluralité de dispositifs de surveillance qui surveillent une pluralité de blocs-batteries comportant chacun une ou plusieurs cellules de batterie secondaire, des informations d'état de batterie du bloc-batterie correspondant, **caractérisé en ce qu'**il comprend :
un moyen de comparaison pour comparer un numéro de séquence lorsque chacun des dispositifs de surveillance est activé avec un numéro d'identification, qui est attribué à chacun des dispositifs de surveillance et est acquis à partir du dispositif de surveillance, lorsque le dispositif de surveillance est activé selon une séquence prédéfinie; et
un moyen de changement pour changer le numéro d'identification au même numéro que le numéro de séquence et pour délivrer en sortie le nouveau numéro d'identification suite au changement au dispositif de surveillance lorsque le numéro de séquence est différent du numéro d'identification.

2. Dispositif de gestion de batterie selon la revendication 1, comprenant en outre :
des moyens de stockage pour stocker le numéro d'identification et des informations spécifiques pour identifier le dispositif de surveillance de manière à les faire correspondre les uns les autres.

3. Dispositif de gestion de batterie selon la revendication 1 ou 2,
dans lequel, lorsque le numéro de séquence et le numéro d'identification correspondent l'un à l'autre, le moyen de changement délivre en sortie une commande d'activation de dispositif de surveillance au dispositif de surveillance, pour laquelle le numéro de séquence et le numéro d'identification ont été comparés l'un avec l'autre, sans changer le numéro d'identification du dispositif de surveillance, de sorte que le dispositif de surveillance, sur un côté aval qui est opposé au dispositif de gestion de batterie lorsque le côté dispositif de gestion de batterie est considéré comme étant un côté amont, soit activé.

4. Dispositif de gestion de batterie selon l'une quelconque des revendications 1 à 3,
dans lequel le dispositif de surveillance délivre en sortie des informations de contact indiquant un fonctionnement normal lorsqu'un moyen de commutation de connexion est dans un état de connexion et délivre en sortie des informations de contact indiquant un échec lorsque le moyen de commutation de connexion est dans un état de non-connexion, le moyen de commutation de connexion réalisant une commutation entre une connexion et une non-connexion en fonction d'un côté aval sur un côté opposé au dispositif de gestion de batterie lorsque le côté dispositif de gestion de batterie est considéré comme étant un côté amont, et
le dispositif de gestion de batterie comporte un moyen de détermination pour déterminer le dispositif de surveillance qui délivre en sortie les informations de contact indiquant un fonctionnement normal comme étant le dispositif de surveillance à une extrémité lorsque les informations de contact indiquant un fonctionnement normal sont détectées dans un état initial.

5. Procédé de commande d'un dispositif de gestion de batterie qui acquiert, à partir de chacun d'une pluralité de dispositifs de surveillance qui surveillent une pluralité de blocs-batteries comportant chacun une ou plusieurs cellules de batterie secondaire, des informations d'état de batterie du bloc-batterie correspondant, le procédé étant **caractérisé en ce qu'**il comprend :
une première étape consistant à comparer un numéro de séquence lorsque chacun des dispositifs de surveillance est activé avec le numéro d'identification, qui est attribué à chacun des dispositifs de surveillance et est acquis à partir du dispositif de surveillance, lorsque le dispositif de surveillance est activé selon une séquence prédéfinie ; et
une seconde étape consistant à changer le numéro d'identification au même numéro que le numéro de séquence et à délivrer en sortie le nouveau numéro d'identification suite au changement au dispositif de surveillance lorsque le numéro de séquence est différent du numéro d'identification.

6. Programme de commande d'un dispositif de gestion de batterie qui acquiert, à partir de chacun d'une pluralité de dispositifs de surveillance qui surveillent une pluralité de blocs-batteries comportant chacun une ou plusieurs cellules de batterie secondaire, des informations d'état de batterie du bloc-batterie correspondant, **caractérisé en ce que** le programme amène un ordinateur à exécuter :
un premier procédé consistant à comparer un numéro de séquence lorsque chacun des dispositifs de surveillance est activé avec le numéro d'identification, qui est attribué à chacun des dispositifs de surveillance et est acquis à partir du dispositif de surveillance, lorsque le dispositif de surveillance est activé selon une séquence prédéfinie ; et
un second procédé consistant à changer le numéro d'identification au même numéro que le numéro de séquence et à délivrer en sortie le nouveau numéro d'identification suite au changement au dispositif de surveillance lorsque le numéro de séquence est différent du numéro d'identification.

7. Système de surveillance de batterie, comprenant :
une pluralité de dispositifs de surveillance qui surveillent une pluralité de blocs-batteries comportant chacun une ou plusieurs cellules de batterie secondaire ; et
un dispositif de gestion de batterie qui acquiert des informations d'état de batterie du bloc-batterie correspondant à partir de chacun des dispositifs de surveillance,
dans lequel chacun des dispositifs de surveillance comporte un moyen de sortie pour délivrer en sortie un numéro d'identification attribué, et
**caractérisé en ce que**
le dispositif de gestion de batterie comporte :
un moyen de comparaison pour comparer un numéro de séquence lorsque le dispositif de surveillance est activé avec le numéro d'identification acquis à partir du dispositif de surveillance lorsque le dispositif de surveillance est activé selon une séquence prédéfinie ; et
un moyen de changement pour changer le numéro d'identification au même numéro que le numéro de séquence et pour délivrer en sortie le nouveau numéro d'identification suite au changement au dispositif de surveillance lorsque le numéro de séquence est différent du numéro d'identification.
